# EUROPÄISCHE PATENTANMELDUNG

(11) **EP 2 960 011 A1**
(43) Veröffentlichungstag der Anmeldung: **30.12.2015**
(21) Anmeldenummer: 15001740.8
(22) Anmeldetag: 11.06.2015
(51) Int. Cl.: B23Q 1/25, B23K 37/02, B23K 11/31, B21J 15/14, B23Q 16/00, H01L 39/14

(54) **POSITIONIEREINRICHTUNG UND BEARBEITUNGSSYSTEM MIT EINER POSITIONIEREINRICHTUNG**

(30) Priorität: 26.06.2014 DE 102014009503
(71) Anmelder: Festo AG & Co. KG, 73734 Esslingen (DE)
(72) Erfinder: Kühn, Lars, 01187 Dresden (DE); de Haas, Oliver, 01097 Dresden (DE)
(74) Vertreter: Patentanwälte Magenbauer & Kollegen Partnerschaft mbB

(57) **Zusammenfassung**

1. Die Erfindung betrifft eine Positioniereinrichtung zur einander gegenüberliegenden Positionierung von Arbeitskomponenten (5, 6) eines Bearbeitungsmittels oder eines Diagnosemittels an einander entgegengesetzten Oberflächen (39, 40) eines plattenförmigen Gegenstands (2), mit einer ersten Halterung (3), die eine erste Arbeitskomponente (5) umfasst und mit einer zweiten Halterung (4), die eine zweite Arbeitskomponente (6) umfasst, wobei die Arbeitskomponenten (5, 6) für eine beidseitige Bearbeitung oder Diagnose des plattenförmigen Gegenstands (2) ausgebildet sind. Erfindungsgemäß ist vorgesehen, dass der ersten Halterung (3) eine erste Trageinrichtung mit einem Supraleiter (19, 20, 21) und der zweiten Halterung (4) eine zweite Trageinrichtung mit einer Permanentmagnetanordnung (26, 27, 28)zugeordnet sind, um eine kontaktlose Beabstandung der beiden Halterungen (3, 4) zueinander zu gewährleisten und wobei die Arbeitskomponente (5, 6) zentral gegenüber der Trageinrichtung (19, 20, 21, 26, 27, 28) angeordnet ist.

## Beschreibung

Die Erfindung betrifft eine Positioniereinrichtung zur einander gegenüberliegenden Positionierung von Arbeitskomponenten eines Bearbeitungsmittels oder eines Diagnosemittels an einander entgegengesetzten Oberflächen eines plattenförmigen Gegenstands, mit einer ersten Halterung, die eine erste Arbeitskomponente umfasst und mit einer zweiten Halterung, die eine zweite Arbeitskomponente umfasst, wobei die Arbeitskomponenten für eine beidseitige Bearbeitung oder Diagnose des plattenförmigen Gegenstands ausgebildet sind. Ferner betrifft die Erfindung ein Bearbeitungssystem mit einer derartigen Positioniereinrichtung.

Aus der DE 197 02 673 A1 ist eine Vorrichtung für das universelle Bearbeiten großer, mit einer Öffnung versehener Platten an Ober- und Unterseite mittels in vertikaler Drehachse liegender Bearbeitungswerkzeuge, bestehend aus der auf Spann- und Stützelementen liegenden, zu bearbeitenden Platte, beidseitig der Platte angeordneten Fahrbahnen für ein die Platte überspannendes Portal und einem Querwagen des Portals, an dem ein die Platte umgreifender Bügel mit Bearbeitungswerkzeugen beidseitig der Platte angeordnet ist, bekannt.

Die Aufgabe der Erfindung besteht darin, eine Positioniereinrichtung und ein Bearbeitungssystem mit einer derartigen Positioniereinrichtung bereitzustellen, die eine Bearbeitung großflächiger, plattenförmiger Gegenstände ermöglicht.

Diese Aufgabe wird gemäß einem ersten Erfindungsaspekt mit den Merkmalen des Anspruchs 1 gelöst. Hierbei ist vorgesehen, dass der ersten Halterung eine erste Trageinrichtung mit einem Supraleiter und der zweiten Halterung eine zweite Trageinrichtung mit einer Permanentmagnetanordnung zugeordnet sind, um eine kontaktlose Beabstandung der beiden Halterungen zueinander zu gewährleisten und wobei die Arbeitskomponente zentral gegenüber der Trageinrichtung angeordnet ist. Mit dem Begriff Supraleiter sollen in diesem Zusammenhang diejenigen Materialien bezeichnet werden, die durch Abkühlung auf oder unterhalb ihrer Sprungtemperatur supraleitende Eigenschaften aufweisen. Mit diesen supraleitenden Eigenschaften des Supraleiters geht einher, dass ein während der Abkühlung auf die Sprungtemperatur auf den Supraleiter einwirkendes Magnetfeld nach Erreichen oder Unterschreiten der Sprungtemperatur des Supraleiters gewissermaßen "eingefroren" wird. Dadurch führt jede Veränderung der räumlichen Lage zwischen Supraleiter und aufgeprägtem Magnetfeld zu Reaktionskräften, die zumindest in gewissen Grenzen eine feste Positionierung des Supraleiters in dem Magnetfeld ohne Einwirkung weiterer von außen zugeführter Energieströme ermöglicht. Erfindungsgemäß umfasst die zweite Halterung, die zur Aufnahme der zweiten Arbeitskomponente vorgesehen ist, eine Permanentmagnetanordnung. Diese Permanentmagnetanordnung kann einen oder mehrere Permanentmagnete umfassen, die beabstandet oder aneinander liegend zueinander angeordnet sind. Bei dem Supraleiter handelt es sich beispielsweise um einen sogenannten Hochtemperatursupraleiter. Ein bekannter Vertreter der Hochtemperatursupraleiter, der mit flüssigem Stickstoff auf seine Sprungtemperatur von 77 Kelvin gekühlt werden kann, ist der Werkstoff Yttrium-Barium-Kupferoxid. Alternativ können auch eisenhaltige Hochtemperatursupraleiter eingesetzt werden. Ferner ist vorgesehen, dass die Arbeitskomponente zentral gegenüber der Trageinrichtung angeordnet ist. Hierdurch wird eine vorteilhafte Kraftübertragung zwischen der Arbeitskomponente und der Trageinrichtung gewährleistet. Dies ist insbesondere dann von Interesse, wenn eine Bearbeitung des plattenförmigen Gegenstands, beispielsweise ein Schweißvorgang oder eine spanabhebender Bearbeitungsvorgang vorgesehen ist. Als plattenförmige Gegenstände im Sinne der Patentanmeldung werden Gegenstände verstanden, die bezogen auf ihre räumliche Ausdehnung eine geringe Dicke aufweisen. Typische Beispiele für plattenförmige Gegenstände sind Tafeln, beispielsweise Blechtafeln oder geschichtete Anordnungen von Blechtafeln.

Vorteilhafte Weiterbildungen der Erfindung sind Gegenstand der Unteransprüche.

Zweckmäßig ist es, wenn die erste Trageinrichtung und die zweite Trageinrichtung jeweils als Anordnung von mehreren, insbesondere drei, Auslegern ausgebildet sind, die sich ausgehend von einer Aufnahme für die Arbeitskomponente erstrecken und die jeweils an einem von der Aufnahme abgewandten Auslegerende mit einem Permanentmagneten oder einem Supraleiter ausgerüstet sind. Mit Hilfe der Ausleger kann eine vorteilhafte Beabstandung der Permanentmagnete beziehungsweise Supraleiter von der Aufnahme für die Arbeitskomponente erreicht werden, ohne dass hierfür ein erheblicher Materialeinsatz notwendig ist. Vielmehr können die Ausleger schlank in der Form von Stangen oder Streben ausgeführt werden, die zumindest im Rahmen der bei bestimmungsgemäßer Anwendung der Positioniereinrichtung auftretenden Kräfte ausreichend formstabil sind. Bevorzugt ist vorgesehen, dass die erste Trageinrichtung und die zweite Trageinrichtung jeweils als Anordnung von genau drei Auslegern ausgebildet sind, wodurch sich im Zusammenspiel der beiden Trageinrichtungen der Halterungen eine eindeutige geometrische Beziehung zwischen den beiden Halterungen erreichen lässt. Eine geometrische Unterbestimmung beziehungsweise Überbestimmung der von den Trageinrichtungen bereitzustellenden Kräfte wird durch diese Maßnahme vermieden.

In weiterer Ausgestaltung der Erfindung ist vorgesehen, dass die Auslegerenden der Trageinrichtung in einer Ebene angeordnet sind, die quer zu einer Arbeitsrichtung der Arbeitskomponente ausgerichtet ist. Bei der Arbeitskomponente handelt es sich exemplarisch um eine Elektrodenanordnung eines Punktschweißgeräts oder eine Kombination einer Röntgenstrahlungsquelle und eines Röntgenstrahlungsempfängers, wobei in beiden Fällen eine eindeutige Arbeitsrichtung für die Wechselwirkung zwischen den beiden Arbeitskomponenten festgelegt werden kann. Für eine Vielzahl von Anwendungsfällen der Positioniereinrichtung ist es vorteilhaft, wenn die Arbeitsrichtung der Arbeitskomponenten senkrecht zur Oberfläche des zu bearbeitenden oder zur diagnostizierenden plattenförmigen Gegenstands ausgerichtet sind, dementsprechend ist in einem derartigen Einsatzfall eine Ausrichtung der Auslagerenden der Trageinrichtung in der quer zur Arbeitsrichtung ausgerichteten Ebene vorteilhaft.

Bevorzugt sind die erste Arbeitskomponente als erste Schweißelektrode und die zweite Arbeitskomponente als zweite Schweißelektrode ausgebildet. Hiermit kann die Positioniereinrichtung in der Art einer Punktschweißzange verwendet werden, ohne jedoch die geometrischen Beschränkungen in Kauf nehmen zu müssen, wie sie bei üblichen C-förmig ausgebildeten Punktschweißzangen berücksichtigt werden müssen. Vielmehr kann die derart ausgestattete Positioniereinrichtung in nahezu unbegrenzter Weise entlang der Oberflächen des plattenförmigen Gegenstands verfahren werden, um an den gewünschten Orten jeweils Schweißvorgänge durchzuführen.

Bei einer alternativen Ausführungsform der Erfindung ist vorgesehen, dass die erste Arbeitskomponente als Strahlungsquelle, insbesondere Röntgenstrahlungsquelle, und die zweite Arbeitskomponente als Strahlungsempfänger, insbesondere als Röntgenstrahlungsempfänger, ausgebildet sind. Eine derartige Positioniereinrichtung kann für eine Diagnose an plattenförmigen Gegenständen mit nahezu unbegrenzter Flächenausdehnung eingesetzt werden, beispielsweise um Materialschäden an Rohren, die ebenfalls im Sinne der Patentanmeldung als plattenförmige Gegenstände betrachtet werden, oder anderen Strukturen detektieren zu können.

In weiterer Ausgestaltung der Erfindung ist vorgesehen, dass eine Halterung mit einer Antriebeinrichtung ausgerüstet ist oder zur Ankopplung einer Antriebseinrichtung ausgebildet ist, um eine Bewegung der beiden Halterungen mit den darin aufgenommenen Arbeitskomponenten entlang eines vorgebbaren Bearbeitungswegs längs der Oberfläche des plattenförmigen Gegenstands zu gewährleisten. Bei der Antriebeinrichtung kann es sich beispielsweise um ein Antriebsrad handeln, das von einem Elektromotor angetrieben wird. Hierzu steht das Antriebsrad in Kontakt mit der Oberfläche des plattenförmigen Gegenstands, um reibschlüssig eine Kraftübertragung zwischen der Positioniereinrichtung und dem Gegenstand zu ermöglichen. Damit wird eine Verfahrbewegung der beiden Halterungen entlang eines vorgebbaren Bearbeitungswegs ermöglicht. Andere kontaktgebundene Antriebsmittel wie Raupen oder Ketten oder kontaktlose Antriebsmittel wie Wirbelstromantriebe oder Strahlantriebe können ergänzend oder alternativ vorgesehen werden, um die Positioniereinrichtung an gewünschte Orte am plattenförmigen Gegenstand bewegen zu können. Alternativ ist vorgesehen, dass eine der Halterungen eine Schnittstelle zur Ankopplung einer Antriebseinrichtung umfasst. Diese Schnittstelle kann beispielsweise als Kupplung für einen Roboterarm ausgebildet sein, sodass die Positioniereinrichtung mittels eines Industrieroboters oder einer anderen Handhabungseinrichtung wie einem Portalkran an beliebige Orte des plattenförmigen Gegenstands geführt werden kann. Entscheidend ist dabei jeweils, dass eine zumindest nahezu vollständig freie Platzierbarkeit der Positioniereinrichtung an dem plattenförmigen Gegenstand gewährleistet werden kann. Eine Beschränkung für die Bewegung der Positioniereinrichtung gegenüber dem plattenförmigen Gegenstand tritt in erster Linie durch die Antriebeinrichtung auf.

Bei einer vorteilhaften Weiterbildung der Erfindung ist vorgesehen, dass einer Aufnahme für die Arbeitskomponente ein Stellmittel zur Beeinflussung einer rotatorischen und/oder translatorischen Ausrichtung des Arbeitsmittels gegenüber der Trageinrichtung zugeordnet ist. Mit Hilfe des Stellmittels kann beispielsweise ein Zustellvorgang für ein Bearbeitungsmittel wie eine Schweißelektrode oder ein spanabhebendes Werkzeug vorgenommen werden. Ergänzend oder alternativ kann mit Hilfe des Stellmittels eine Veränderung der Winkellage der Arbeitskomponente gegenüber der Oberfläche des plattenförmigen Gegenstands ermöglicht werden, beispielsweise um bei einem Diagnosevorgang eine Kombination einer Strahlungsquelle und eines Strahlungsempfängers in eine besonders vorteilhafte Ausrichtung gegenüber der Oberfläche des plattenförmigen Gegenstands bringen zu können. Bei dem Stellmittel handelt es sich exemplarisch um einen elektrischen oder fluidischen Linear- oder Drehantrieb oder eine Kombination hiervon. Beispielsweise kann mit Hilfe des Stellmittels auch ein Anpressdruck einer Schweißelektrode auf die Oberfläche des plattenförmigen Gegenstands eingestellt werden, insbesondere geregelt, werden.

Zweckmäßig ist es, wenn den Trageinrichtungen eine Einstelleinrichtung für eine Einstellung eines Abstands zwischen den Halterungen vor und/oder während eines Bearbeitungsvorgangs oder eines Diagnosevorgangs an dem plattenförmigen Gegenstand zugeordnet ist. Bei der Einstelleinrichtung kann es sich beispielsweise um eine Magnetspulenanordnung handeln, die für eine Wechselwirkung mit der Permanentmagnetanordnung der ersten Trageinrichtung vorgesehen ist, um während eines Abkühlungsvorgangs für den Supraleiter eine vorgebbare Beabstandung zwischen den Trageinrichtungen vorzugeben. Eine Einstelleinrichtung kann zusätzlich dazu vorgesehen sein, während des Bearbeitungsvorgangs oder Diagnosevorgangs an dem plattenförmigen Gegenstand eine Beabstandung der Trageinrichtungen zu steuern oder gegebenenfalls in Abhängigkeit von einem Messwert eines Sensorsystems, insbesondere eines Abstandssensorsystems, zu regeln. Eine derartige Einstellung oder Regelung des Abstands zwischen den Halterungen ist insbesondere dann von Vorteil, wenn der plattenförmige Gegenstand Bereiche mit unterschiedlicher Dicke und/oder Krümmung aufweist, die eine entsprechende Anpassung des Abstands der Halterungen erfordert und/oder wenn zur Durchführung des Bearbeitungsvorgangs oder Diagnosevorgangs eine Veränderung des Abstands zwischen den Halterungen von Vorteil ist.

Vorteilhaft ist es, wenn der ersten Trageinrichtung eine Kühleinrichtung für eine Kühlung des Supraleiters während der Durchführung eines Bearbeitungsvorgangs oder eines Diagnosevorgangs zugeordnet ist. Bei der Kühleinrichtung handelt es sich vorzugsweise um eine elektrisch betriebene Kühleinrichtung, die eine dauerhafte Kühlung des Supraleiters auf seine oder unter seine Sprungtemperatur gewährleisten kann, um damit einen zeitlich unbegrenzten Betrieb der Positioniereinrichtung zu ermöglichen. Dabei kann wahlweise vorgesehen sein, dass die erste Trageinrichtung genau eine Kühleinrichtung umfasst, die über geeignete Wärmeleitungsstrukturen mit dem oder den Supraleitern verbunden ist. Alternativ kann vorgesehen sein, dass an der ersten Trageinrichtung mehrere Kühleinrichtungen ausgebildet sind, die für eine lokale Kühlung des Supraleiters oder für eine individuelle Kühlung jeweils eines von mehreren Supraleitern vorgesehen sind.

Die Aufgabe der Erfindung wird gemäß einem zweiten Erfindungsaspekt für ein Bearbeitungssystem mit den Merkmalen des Anspruchs 10 gelöst. Hierbei ist vorgesehen, dass das Bearbeitungssystem eine Positioniereinrichtung nach einem der Ansprüche 1 bis 7 umfasst und dass eine stationäre Kühleinrichtung für eine Kühlung des Supraleiters vor der Durchführung eines Bearbeitungsvorgangs oder eines Diagnosevorgangs vorgesehen ist, die eine Einstelleinrichtung zur Einstellung eines Abstands zwischen der ersten Halterung und der zweiten Halterung für die Durchführung des Bearbeitungsvorgangs oder Diagnosevorgangs in Abhängigkeit von einer Dicke des plattenförmigen Gegenstands umfasst. Durch die Verwendung der stationären Kühleinrichtung können die Halterungen der Positioniereinrichtung einfach gestaltet werden, da sie keine individuelle Kühleinrichtung benötigen. Vielmehr findet vor der Durchführung des Bearbeitungsvorgangs oder Diagnosevorgangs eine Abkühlung der Supraleiter der ersten Trageinrichtung in der stationären Kühleinrichtung statt. Dabei wird eine Einstellung des Abstands zwischen der ersten Halterung und der zweiten Halterung mit Hilfe einer Einstelleinrichtung vorgenommen, die der stationären Kühleinrichtung zugeordnet ist. Bei dieser Einstelleinrichtung kann es sich beispielsweise um einen Linearantrieb handeln, der eine lineare Positionierung der ersten Halterung gegenüber der zweiten Halterung in einem Abstand gewährleistet, der in vorteilhafterweise an die Dicke des plattenförmigen Gegenstands angepasst ist und der bis zum Erreichen oder Unterschreiten der Sprungtemperatur des Supraleiters in der Kühleinrichtung beibehalten wird. Durch diese Maßnahmen kann eine einfache und kostengünstige Gestaltung der beiden Halterungen erzielt werden. Ergänzend kann eine derartige Einstelleinrichtung dazu eingesetzt werden, vor einem Einsatz der Positioniereinrichtung zunächst eine Beabstandung der Halterungen während des Abkühlvorgangs sicherzustellen, um dann in einem nachfolgenden Schritt eine Vergrößerung des Abstands zwischen den Halterungen herbeizuführen, damit diese von einem Bediener oder einem Manipulator getrennt werden können. Bei einer nachfolgenden Annäherung der beiden Halterungen nehmen diese wieder die bei der Abkühlung vorgegebene Beabstandung ein. Somit kann die Positioniereinrichtung beispielsweise zur Diagnose eines umrahmten, flächigen Gegenstands eingesetzt werden, bei dem die Dicke des Rahmens größer als ein Arbeitsabstand der beiden Halterungen der Positioniereinrichtung ist. Exemplarisch wird ein Abstand zwischen den Halterungen während der Abkühlung auf 10mm eingestellt, ein Rahmen eines zu untersuchenden Bildes hat jedoch eine Dicke von 50mm. Dementsprechend werden die beiden Halterungen nach der Abkühlung voneinander getrennt und von beiden Seiten im Bereich der Bilderleinwand wieder aneinander angenähert, wobei dadurch der Bilderrahmen problemlos überwunden werden kann.

Eine vorteilhafte Ausführungsform der Erfindung ist in der Zeichnung dargestellt. Hierbei zeigt:
- Figur 1: eine schematische Seitenansicht einer ersten Halterung zur Verwendung als Punktschweißgerät,
- Figur 2: eine Draufsicht auf die erste Halterung gemäß der Figur 1,
- Figur 3: eine Seitenansicht einer zweiten Halterung zur Verwendung als Punktschweißgerät,
- Figur 4: eine Draufsicht auf die zweite Halterung gemäß der Figur 3 und
- Figur 5: eine schematische Darstellung einer Positioniereinrichtung für Schweißelektroden während einer Vorbereitung zur Verwendung als Punktschweißgerät und
- Figur 6: eine Verwendung der Positioniereinrichtung gemäß Figur 5 als Punktschweißgerät.

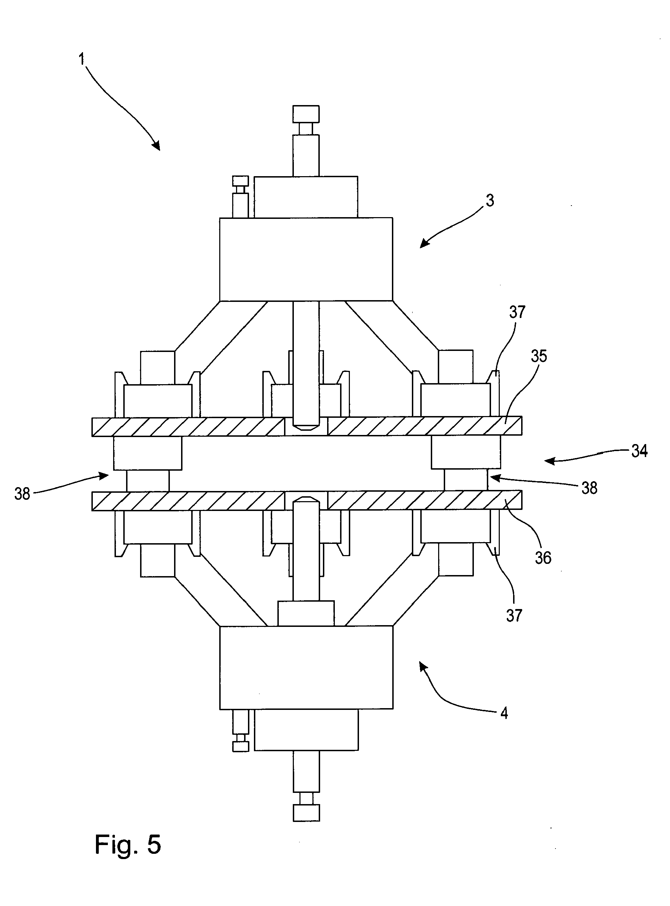

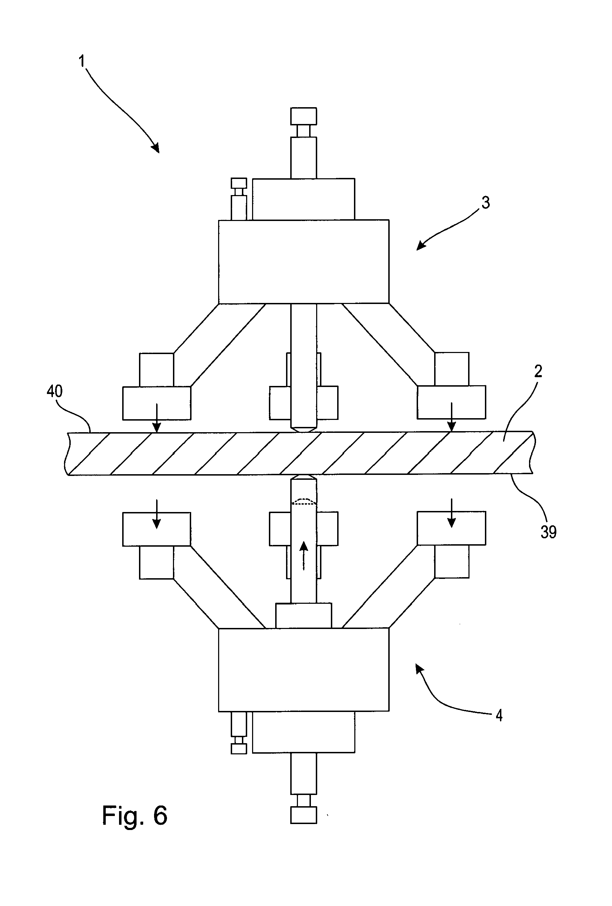

Eine in den Übersichtsdarstellungen gemäß den Figuren 5 und 6 gezeigte Positioniereinrichtung 1, die zur Positionierung von Arbeitskomponenten an einander entgegengesetzten Oberflächen eines plattenförmigen Gegenstands 2 ausgebildet ist, umfasst eine erste Halterung 3 sowie eine zweite Halterung 4. Jede der Halterungen 3, 4 ist exemplarisch zur Aufnahme einer Schweißelektrode 5, 6 vorgesehen, so dass die Positioniereinrichtung 1 bei dieser exemplarischen Ausführungsform als Punktschweißzange eingesetzt werden kann, wie dies nachstehend näher noch beschrieben wird.

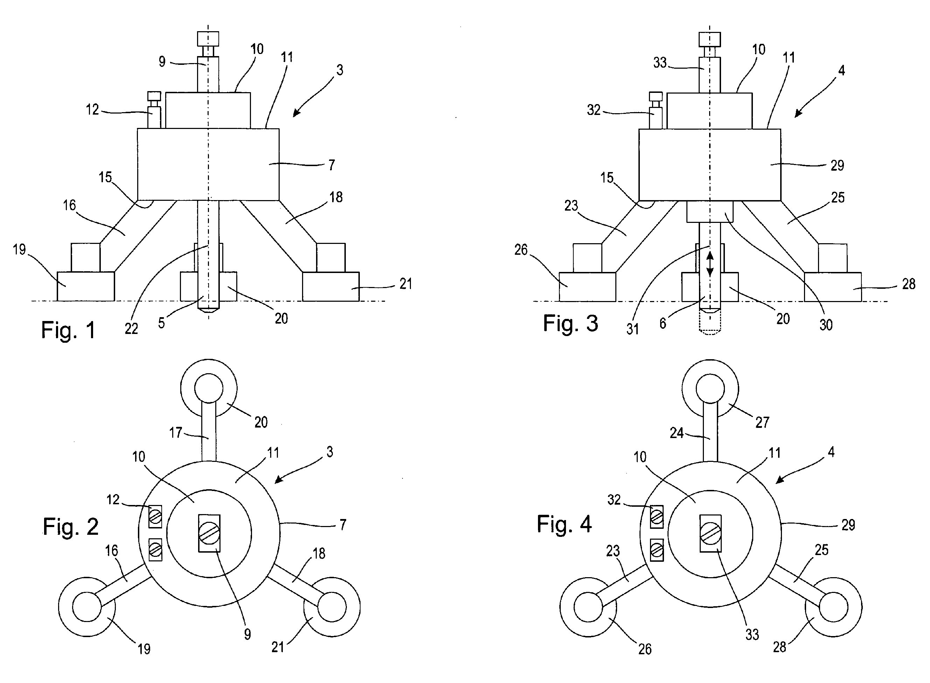

Die in den Figuren 1 und 2 dargestellte erste Halterung 3 umfasst einen Grundkörper 7, in dem eine nicht näher dargestellte Kühleinrichtung angeordnet ist, die zur Kühlung von Supraleitern, insbesondere von Hochtemperatursupraleitern, ausgelegt ist. Beispielsweise ist die nicht dargestellte Kühleinrichtung dazu vorgesehen, eine Abkühlung auf eine Temperatur von weniger als 100 Kelvin zu ermöglichen, um einen Supraleiter im Bereich seiner Sprungtemperatur oder darunter temperieren zu können und somit die supraleitenden Eigenschaften bereitzustellen. An dem Grundkörper 7 ist eine nicht näher dargestellte Ausnehmung vorgesehen, in der eine stabförmige Schweißelektrode 8 angeordnet ist. Die Schweißelektrode 8 ist in elektrisch isolierter Weise im Grundkörper 7 festgelegt und steht in elektrischer Verbindung mit einer Anschlussklemme 9, die an einer oberen Stirnfläche 10 des Grundkörpers 7 angeordnet ist. An der Anschlussklemme 9 kann ein nicht dargestelltes Stromkabel, insbesondere ein Verbindungskabel zu einem Schweißtransformator, angeschlossen werden. Ferner sind an einer zweiten, ringförmig ausgebildeten Stirnfläche 11 des Grundkörpers 7 zwei Anschlussklemmen 12 angeordnet, die für einen Anschluss eines nicht dargestellten Versorgungskabels vorgesehen sind, über das elektrische Energie an die ebenfalls nicht dargestellte Kühleinrichtung im Grundkörper 7 bereitgestellt werden kann.

An einer unteren Stirnfläche 15 des Grundkörpers 7 sind exemplarisch drei Streben 16, 17 und 18 angeordnet, die jeweils an einem vom Grundkörper 7 abgewandten Endbereich einen Supraleiter 19, 20, 21 tragen. Zwischen den Supraleitern 19, 20, 21 und der nicht dargestellten Kühleinrichtung im Grundkörper 7 sind durch die Streben 16, 17 und 18 hindurch jeweils nicht dargestellte Wärmeleitmittel geführt, die eine energieeffiziente Kühlung der Supraleiter 19, 20, 21 durch die im Grundkörper 7 aufgenommene Kühleinrichtung ermöglichen. Exemplarisch sind die Streben 16, 17, 18 in einer Winkelteilung von jeweils 120° zu einer Mittelachse 22 des beispielhaft kreiszylindrisch ausgebildeten Grundkörpers 7 angeordnet. Ferner ist exemplarisch vorgesehen, dass jede der Streben 16, 17, 18 einen, vorzugsweise jeweils gleichen, Winkel gegenüber der Mittelachse 22 einnimmt. Durch diese Ausrichtung der Streben 16, 17 und 18 wird eine vorteilhafte Vergrößerung der Aufstandsfläche für die erste Halterung 3 sichergestellt, wodurch eine Verkippung der ersten Halterung 3 bei Verwendung in der Positioniereinrichtung 1, wie sie in den Figuren 5 und 6 dargestellt ist, zumindest weitgehend ausgeschlossen werden kann.

Die in den Figuren 3 und 4 dargestellte zweite Halterung 4 unterscheidet sich von der in den Figuren 1 und 2 dargestellten ersten Halterung 3 dadurch, dass keine Kühleinrichtung integriert ist und dass an den Endbereichen der Streben 23, 24 und 25 jeweils Permanentmagnete 26, 27 und 28 angeordnet sind. Ferner ist die zweite Schweißelektrode 6 an einem im Grundkörper 29 aufgenommenen Linearsteller 30 festgelegt, bei dem es sich exemplarisch um einen elektrischen Linearantrieb handelt. Mit Hilfe des Linearstellers 30 kann die zweite Schweißelektrode 6 entlang der Mittelachse 31 der zweiten Halterung 4 verstellt werden. Eine elektrische Versorgung des Linearstellers 30 wird mit Hilfe der Anschlussklemmen 32 gewährleistet. Die Anschlussklemme 33 dient in gleicherweise wie die Anschlussklemme 9 zur elektrischen Verbindung der zweiten Schweißelektrode 6 mit einem nicht dargestellten Schweißtransformator.

Für eine Inbetriebnahme der in Figur 5 dargestellten Positioniereinrichtung 1, die exemplarisch zur Verwendung als Punktschweißeinrichtung vorgesehen ist, erfolgt zunächst eine Anordnung eines Einstellmittels 34 zwischen der ersten Halterung 3 und der zweiten Halterung 4. Exemplarisch umfasst das Einstellmittel 34 zwei parallel zueinander ausgerichtete Anlageplatten 35, 36, die jeweils mit Haltemitteln 37 zur ortsfesten Festlegung der ersten Halterung 3 und der zweiten Halterung 4 vorgesehen sind. Ferner umfasst das Einstellmittel 34 eine Verstelleinrichtung 38, die eine Einstellung der Beabstandung der beiden Anlageplatten 35, 36 zueinander ermöglicht, um die beiden Halterungen 3, 4 während der Inbetriebnahme der Positioniereinrichtung 1 in einen vorgebbaren Abstand zueinander zu bringen. Anschließend erfolgt die Aktivierung der im Grundkörper 7 aufgenommenen, nicht näher dargestellten, Kühleinrichtung zur Abkühlung der Supraleiter 19, 20, 21 auf die beziehungsweise unter die Sprungtemperatur. Hierdurch erfolgt ein "Einfriervorgang" für die von den gegenüberliegend zu den Supraleitern 19, 20, 21 angeordneten Permanentmagneten 26, 27, 28 bereitgestellten Magnetfeldern in den Supraleitern 19, 20, 21. Somit wird nach Erreichen oder Unterschreiten der Sprungtemperatur der Supraleiter 19, 20, 21 auch bei Entfernen des Einstellmittels 34 der vorgegebene Abstand zwischen den beiden Halterungen 3, 4 beibehalten, solange die Kühlung für die Supraleiter 19, 20, 21 aufrechterhalten bleibt. Nach erfolgter Abkühlung der Supraleiter 19, 20, 21 kann die Positioniereinrichtung 1 manuell oder unter Zuhilfenahme eines Manipulators wie beispielsweise eines Industrieroboters zur Durchführung des Bearbeitungs- oder Diagnosevorgangs auf den plattenförmigen Gegenstand 2 aufgeschoben werden, wie dies in Figur 6 dargestellt ist. Exemplarisch kommt hierbei die erste Halterung 3 beispielsweise oberhalb des plattenförmigen Gegenstands 2 zu liegen während die zweite Halterung 4 unterhalb des plattenförmigen Gegenstands 2 angeordnet ist und wobei der Abstand zwischen den beiden Halterungen 3, 4 aufrechterhalten bleibt. Nach Erreichen einer Zielposition am plattenförmigen Gegenstand 2 kann ferner vorgesehen werden, durch Bereitstellung elektrischer Energie an den Anschlussklemmen 32 eine Bewegung des Linearstellers 30 hervorzurufen, wodurch eine Annäherungsbewegung der zweiten Schweißelektrode 6 an die Unterseite 39 des plattenförmigen Gegenstands 2 erfolgt. Sobald die zweite Schweißelektrode 6 in Anlage zur Unterseite 39 kommt, verlagert sich die zweite Halterung 4 gegenüber dem plattenförmigen Gegenstand 2 in einer Entfernungsbewegung, wie dies durch die Pfeile in der Figur 6 dargestellt ist. Da jedoch die erste Halterung 3 auf Grund der Wechselwirkung zwischen den Supraleitern 19, 20, 21 und den Permanentmagneten 26, 27, 28 ein konstanten Abstand gegenüber der zweiten Halterung 4 einhält, gelangt auch die erste Schweißelektrode 5 in Kontakt mit einer Oberseite 40 des plattenförmigen Gegenstands 2. Somit wird sowohl von der ersten Schweißelektrode 5 als auch von der zweiten Schweißelektrode 6 eine Krafteinwirkung auf den plattenförmigen Gegenstand 2 hervorgerufen, die als Anpressdruck für die Erzeugung eines Schweißpunkts dient. Dementsprechend wird in einem nachfolgenden Schritt eine Beaufschlagung der beiden Schweißelektroden 5, 6 mit elektrischer Energie über die jeweiligen Anschlussklemmen 9, 33 vorgenommen, sodass der gewünschte Schweißpunkt erzeugt werden kann.

Für eine Bewegung der Positioniereinrichtung 1 entlang des plattenförmigen Gegenstands 2 kann ein externer Manipulator wie beispielsweise ein Industrieroboter eingesetzt werden, der beispielsweise an dem kreiszylindrisch ausgeführten Grundkörper 7 oder 29 der jeweiligen Halterung 3 oder 4 angreift. Bei einer nicht näher dargestellten Ausführungsform der Positioniereinrichtung ist eine spezifisch an einen Industrieroboter angepasste elektromechanische Schnittstelle vorgesehen, die zum einen eine Festlegung einer der Halterungen am Industrieroboter ermöglicht und zum anderen auch eine Energieübertragung zwischen dem Industrieroboter und der jeweiligen Halterung gewährleistet. Die jeweils andere Halterung muss hingegen lediglich elektrisch kontaktiert werden, um beispielsweise einen Schweißstrom abführen zu können und/oder den zugeordneten Linearsteller 30 betätigen zu können. Mit einer derartigen Positioniereinrichtung 1 können großflächige plattenförmige Gegenstände 2 mit ebener oder gekrümmter Oberfläche bis hin zu Rohren an zumindest nahezu jeder beliebigen Stelle bearbeitet werden, da keine mechanische Verbindung zwischen der ersten Halterung 3 und der zweiten Halterung 4 notwendig ist. Vielmehr wird der Bezug zwischen den beiden Halterungen 3, 4 durch die jeweiligen Trageinrichtungen in Form der Supraleiter 19, 20, 21 beziehungsweise der Permanentmagnete 26, 27, 28 sichergestellt.

Bei einer ebenfalls nicht dargestellten Ausführungsform eines Bearbeitungssystems wird abweichend von der Darstellung der Figuren 5 und 6 bei der ersten Halterung auf eine aktive Kühlung der zugeordneten Supraleiter verzichtet. Vielmehr ist vorgesehen, die Supraleiter abseits des plattenförmigen Gegenstands in einer stationären Kühleinrichtung vor der Durchführung des Bearbeitungs- oder Diagnosevorgangs abzukühlen und anschließend innerhalb eines von Umgebungsbedingungen wie einer Außentemperatur und einem Wärmeeintrag in die jeweilige Halterung während des Durchführung des Bearbeitungs- oder Diagnosevorgangs abhängigen Zeitfenstern die gewünschte Bearbeitung oder Diagnose durchzuführen. Dabei kann die nicht dargestellte stationäre Kühleinrichtung mit einer Einstelleinrichtung zur Einstellung des Abstands zwischen der ersten Halterung und der zweiten Halterung in der Art des Einstellmittels 34 ausgerüstet sein, um eine gezielte Anpassung des Abstands zwischen den beiden Halterungen in Abhängigkeit von der Dicke des plattenförmigen Gegenstands einstellen zu können.

Bei einer ebenfalls nicht dargestellten Variante der Positioniereinrichtung 1 sind den Supraleitern jeweils zusätzliche Magnetspulen zugeordnet, die zur Einflussnahme auf die Magnetfelder der Permanentmagnete der gegenüberliegend anzuordnenden Halterung vorgesehen sind. Die zusätzlichen Magnetspulen können beispielsweise eine zusätzliche Anziehungskraft oder eine Abstoßungskraft auf die gegenüberliegende Halterung ausüben, um eine Einstellung eines Arbeitsspalts zwischen den beiden Halterungen zu ermöglichen. Insbesondere kann eine Reduzierung des Arbeitsspalts zwischen den beiden Halterungen bei Erreichen einer Arbeitsposition zur örtlichen Festlegung der Positioniereinrichtung vorgesehen sein.

Bei einer ebenfalls nicht dargestellten Ausführungsform ist wenigstens einer der Halterungen eine Antriebseinrichtung zugeordnet, die beispielsweise als angetriebenes Rad oder Anordnung von angetriebenen Rädern ausgebildet sein kann und die dazu vorgesehen ist, eine autarke Positionsveränderung für die Positioniereinrichtung ohne Verwendung eines Manipulators zu ermöglichen, in dem sich die Räder jeweils an der Oberfläche des plattenförmigen Gegenstands abstützen und geeignete Antriebskräfte auf die Positioniereinrichtung ausüben können.

## Patentansprüche

1. Positioniereinrichtung zur einander gegenüberliegenden Positionierung von Arbeitskomponenten (5, 6) eines Bearbeitungsmittels oder eines Diagnosemittels an einander entgegengesetzten Oberflächen (39, 40) eines plattenförmigen Gegenstands (2), mit einer ersten Halterung (3), die eine erste Arbeitskomponente (5) umfasst und mit einer zweiten Halterung (4), die eine zweite Arbeitskomponente (6) umfasst, wobei die Arbeitskomponenten (5, 6) für eine beidseitige Bearbeitung oder Diagnose des plattenförmigen Gegenstands (2) ausgebildet sind, **dadurch gekennzeichnet, dass** der ersten Halterung (3) eine erste Trageinrichtung mit einem Supraleiter (19, 20, 21) und der zweiten Halterung (4) eine zweite Trageinrichtung mit einer Permanentmagnetanordnung (26, 27, 28) zugeordnet sind, um eine kontaktlose Beabstandung der beiden Halterungen (3, 4) zueinander zu gewährleisten und wobei die Arbeitskomponente (5, 6) zentral gegenüber der Trageinrichtung (19, 20, 21, 26, 27, 28) angeordnet ist.

2. Positioniereinrichtung nach Anspruch 1, **dadurch gekennzeichnet, dass** die erste Trageinrichtung (19, 20, 21) und die zweite Trageinrichtung (26, 27, 28) jeweils als Anordnung von mehreren, insbesondere drei, Auslegern (16, 17, 18) ausgebildet sind, die sich ausgehend von einer Aufnahme (7, 29) für die Arbeitskomponente (5, 6) erstrecken und die jeweils an einem von der Aufnahme (7, 29) abgewandten Auslegerende mit einem Permanentmagneten (26, 27, 28) oder einem Supraleiter (19, 20, 21) ausgerüstet sind.

3. Positioniereinrichtung nach Anspruch 2, **dadurch gekennzeichnet, dass** die Auslegerenden der Trageinrichtung (19, 20, 21, 26, 27 ,28) in einer Ebene angeordnet sind, die quer zu einer Arbeitsrichtung (22) der Arbeitskomponente (5, 6) ausgerichtet ist.

4. Positioniereinrichtung nach Anspruch 1, 2 oder 3, **dadurch gekennzeichnet, dass** die erste Arbeitskomponente (5) als erste Schweißelektrode und die zweite Arbeitskomponente (6) als zweite Schweißelektrode ausgebildet sind.

5. Positioniereinrichtung nach Anspruch 1, 2 oder 3, **dadurch gekennzeichnet, dass** die erste Arbeitskomponente (5) als Strahlungsquelle, insbesondere Röntgenstrahlungsquelle, und die zweite Arbeitskomponente (6) als Strahlungsempfänger, insbesondere als Röntgenstrahlungsempfänger, ausgebildet sind.

6. Positioniereinrichtung nach einem der vorhergehenden Ansprüche, **dadurch gekennzeichnet, dass** eine Halterung (3, 4) mit einer Antriebseinrichtung ausgerüstet ist oder zur Ankopplung einer Antriebseinrichtung ausgebildet ist, um eine Bewegung der beiden Halterungen (3, 4) mit den daran aufgenommenen Arbeitskomponenten (5, 6) entlang eines vorgebbaren Bearbeitungswegs längs der Oberfläche (39, 40) des plattenförmigen Gegenstands (2) zu gewährleisten.

7. Positioniereinrichtung nach einem der vorhergehenden Ansprüche, **dadurch gekennzeichnet, dass** einer Aufnahme (7, 29) für die Arbeitskomponente (5, 6) ein Stellmittel (30) zur Beeinflussung einer rotatorischen und/oder translatorischen Ausrichtung des Arbeitsmittels (5, 6) gegenüber der Trageinrichtung (19, 20, 21, 26, 27, 28) zugeordnet ist.

8. Positioniereinrichtung nach einem der vorhergehenden Ansprüche, **dadurch gekennzeichnet, dass** den Trageinrichtungen eine Einstelleinrichtung für eine Einstellung eines Abstands zwischen den Halterungen vor und/oder während eines Bearbeitungsvorgangs oder eines Diagnosevorgangs an dem plattenförmigen Gegenstand (2) zugeordnet ist.

9. Positioniereinrichtung nach einem der vorhergehenden Ansprüche, **dadurch gekennzeichnet, dass** der ersten Trageinrichtung (19, 20, 21) eine Kühleinrichtung für eine Kühlung des Supraleiters während der Durchführung eines Bearbeitungsvorgangs oder eines Diagnosevorgangs zugeordnet ist.

10. Bearbeitungssystem mit einer Positioniereinrichtung (1) nach einem der Ansprüche 1 bis 7, **dadurch gekennzeichnet, dass** eine stationäre Kühleinrichtung für eine Kühlung des Supraleiters (19, 20, 21) vor der Durchführung eines Bearbeitungsvorgangs oder eines Diagnosevorgangs vorgesehen ist, die eine Einstelleinrichtung zur Einstellung eines Abstands zwischen der ersten Halterung (3) und der zweiten Halterung (4) für die Durchführung des Bearbeitungsvorgangs oder eines Diagnosevorgangs in Abhängigkeit von einer Dicke des plattenförmigen Gegenstands umfasst.
